# EUROPÄISCHE PATENTANMELDUNG

(11) **EP 1 860 706 A1**
(43) Veröffentlichungstag der Anmeldung: **28.11.2007**
(21) Anmeldenummer: 06010792.7
(22) Anmeldetag: 26.05.2006
(51) Int. Cl.: H01L 31/052, H01L 31/058, H01L 31/048, F24J 2/04

(54) **GFK basiertes Thermo-Photovoltaik Dacheindeckungs- und Wandverkleidungselement**

(71) Anmelder: Stracke, H.-J., 57555 Brachbach (DE)
(72) Erfinder: Stracke, H.-J., 57555 Brachbach (DE)

(57) **Zusammenfassung**

Das GFK Thermo- Photovoltaik Dacheindeckungs- und Wandverkleidungselement als ein beliebig großes und formbares Element ermöglicht die Gewinnung der Solarenergie in Form von Strom und Wärme. Über die Photovoltaikzellen wird Strom gewonnen, wobei der Wirkungsgrad der Stromgewinnung durch ein Kühlsystem erhöht wird, dessen Abwärme durch die Funktion einer Thermosolaranlage an einen Pufferspeicher abgegeben wird.

## Beschreibung

Die Erfindung stammt aus der Produktfertigung mit glasfaserverstärkten Kunststoffen (GFK) und bezieht sich im Besonderen auf die Herstellung von Thermo-Photovoltaik Dacheindeckungs- und Wandverkleidungselementen mit Möglichkeit der Strom- und Wärmegewinnung.
Die Elemente zeichnen sich aus durch ihr niedriges Flächengewicht, ihre Resistenz gegenüber mechanischen Beschädigungen im Vergleich zu herkömmlichen Photovoltaik- /(PV)-Modulen und durch eine einfache individuelle Anfertigung von speziellen Formteilen (z.B. Abschrägung bei Kehlen). Ferner bieten sie die Möglichkeit, gleichzeitig sowohl Strom- als auch Wärmegewinne zu erzielen.

Sonnenenergie kann auf zwei grundlegende Arten genutzt werden: zum einen zur Gewinnung von Strom (Photovoltaik) und zum anderen zur Wärmegewinnung (Solarthermie).
Beide Nutzungsarten sind unterschiedliche Technologien.
Bei der Nutzung solarer Energien sind bereits verschiedenste Ausführungen von Photovoltaik- /(PV)-Modulen und Anlagen für die Solarthermie mit unterschiedlichsten Vor- und Nachteilen bekannt.

Der Bau der PV-Module ist dadurch gekennzeichnet, dass eine bestimmte Anzahl von Photovoltaikzellen zu einem Modul zusammengefasst werden. Bei den meisten Herstellverfahren werden die Photovoltaikzellen in einem Modul, bestehend aus einem Rahmen, einer Unterkonstruktion und einer oberen Abdeckung eingebaut.
Als obere Abdeckung zum Schutz der Photozellen werden häufig antireflexive, bruchsichere Glasscheiben (ESG-Verglasung) verwendet, die jedoch der Grund für ein hohes Flächengewicht der Einzelelemente sind und bedingen, dass die einzelnen Elemente in ihren Ausmaßen und Formen begrenzt sind. Ferner stellt Glas bezüglich der Bruchsicherheit ein erhöhtes Risiko dar.
Zur Reduzierung des Gewichts und zum Schutz gegenüber mechanischen Beanspruchungen kommen auch Plexiglas-Scheiben zur Abdeckung der Photovoltaikzellen zum Einsatz; jedoch haben diese Elemente in der Regel eine verkürzte Lebensdauer von ca. 15 Jahren, da durch ein Verkratzen der Oberfläche bedingt durch äußere Umwelteinflüsse der Wirkungsgrad der Elemente langsam reduziert wird.
Die Form der einzelnen Elemente ist bei der Anwendung des Rahmensystems mit Abdeckscheibe zumeist nur eingeschränkt möglich.
Die Elemente sind quadratisch und werden in Dachflächen entsprechend eingebaut. Dadurch ergibt sich eine schlechte Ausnutzung der betreffenden Dachfläche; individuelle Formen sind nur mit hohem Aufwand herstellbar. Ferner sind diese Rahmen in der Regel verklebt oder vernietet.
Mit zunehmender Lebensdauer können diese Verbindungen durch hohe Sommertemperaturen ihre Dichtigkeit verlieren.
Ein weiteres Problem der Photovoltaikzellen ist es, dass sich ihr Wirkungsgrad bedingt durch hohe Temperaturen verschlechtert. Durch Kühlung der Zellen zum Schutz vor Überhitzung kann der Wirkungsgrad konstant gehalten werden.

Ziel der vorliegenden Erfindung ist es, ein Thermo-Photovoltaik-Element als Ersatz für konventionelle Dacheindeckungen und Wandverkleidungen herzustellen, dass zur Gewinnung solarer Energien dient und aufgrund seines niedrigen Flächengewichts als großflächiges Element gefertigt und eingebaut werden kann. Durch große, individuell angefertigte Elemente, deren Abmessung und Form sehr variabel herstellbar ist, ist eine gute Anpassung an jede Dachform möglich.
Da durch die mögliche Großflächigkeit der Elemente (für den Transport begrenzte Länge ca. 15 m) wenige Elemente, relativ gesehen, bezogen auf die gesamte Dach- / Wandfläche benötigt werden, ergeben sich bedingt durch die reduzierte Elementzahl eine niedrige Anzahl von Anschlüssen und damit verbunden geringe Anschlussverluste.
Die Photovoltaikzellen, deren Wirkungsgrad durch ein integriertes Kühlsystem auch bei hohen Sommertemperaturen konstant bleibt, dienen der Stromerzeugung. Die bei der Kühlung als Abfallprodukt entstehende Wärme wird über einen Wärmetauscher an einen Pufferspeicher abgegeben und dient so der Warmwasserbereitung.
Bedingt durch die Wahl von GFK-Laminat als Träger der Elemente können individuell gefertigte, variable Elementformen realisiert werden, die sich in verschiedenen dekorativen Farben einfärben lassen.

Zur Verdeutlichung der Idee wird im folgenden Abschnitt die Ausführung der Elemente erläutert und in Bezug auf die beigefügten Zeichnungen dargestellt.

| | |
|---|---|
| ■ Fig. 1 : | Aufbau des Thermo-/ Photovoltaik-Elements |
| ■ Fig. 2 : | ausgezogene Zeichnung der Einzelbauteile |
| ■ Fig. 3 : | Querschnitt durch ein Element |
| ■ Fig. 4 : | bestehend aus Fig. 4.1 und Fig. 4.2 schematische Darstellung der Montage / Übergreifungen der Elementanschlüsse |

Die Nummerierung der Einzelbestandteile ist in der Beschreibung und in den Zeichnungen identisch: (1) Unterkonstruktion aus GFK-Laminat,
(2) Photovoltaikzellen, (3) obere Beschichtung aus GFK-Laminat oder einer Polyurethan- (PU) Beschichtung, (4) Kupferrohr-System zur Kühlung der Photovoltaikzellen, (5) Kupferlochblech zur besseren Aufnahme und Ableitung der Wärmeenergie, (6) Übergreifungen als Elementverbindung.

Durch die Verwendung von GFK-Laminat als Untergrund (1) oder Träger des gesamten Elements und einer oberen Polyurethan- (PU) Beschichtung oder GFK-Laminat (3) sind die Photovoltaikzellen (2), die im noch viskosen Zustand auf das GKF-Laminat der Unterkonstruktion aufgebracht werden und nach Erhärtung die obere Schutzschicht (3) erhalten, dauerhaft eingebettet.
Das Auftreten von möglichen Schwachstellen einer Rahmenkonstruktion durch hohe Sommertemperaturen entfällt.

Das komplette Element verfügt aufgrund der Beständigkeit des verwendeten glasfaserverstärkten Kunststoffes über eine sehr gute Haltbarkeit und ist nahezu unanfällig gegenüber mechanischer Beschädigung.
Um die Stabilität der Elemente zu verbessern, erhalten sie an den Rändern Abkantungen und ggf. zusätzliche Querverbindungen.
Die Übergreifungen (6) sorgen, wie bei einer konventionellen Dacheindeckung entsprechend der Dacheindeckungsrichtlinien, für die wasserdichte Verlegbarkeit der Elemente
(Fig. 4.1 / 4.2).

Durch eine zusätzliche Einlaminierung eines Kupferrohr-Systems (4) in die Unterkonstruktion aus GFK-Laminat (1) als Träger ist es möglich, die Photovoltaikzellen (2) zu kühlen und ihren Wirkungsgrad auch bei hoher Sonnenintensität konstant zu halten. Um die Kühlung effektiver zu gestalten werden zusätzlich Kupferlochbleche (5) zur flächenmäßigen Aufnahme der Wärme einlaminiert. Die als Abfallprodukt gewonnene Wärme wird über einen Wärmetauscher an einen Pufferspeicher abgegeben und zur Warmwasser-Bereitung genutzt.

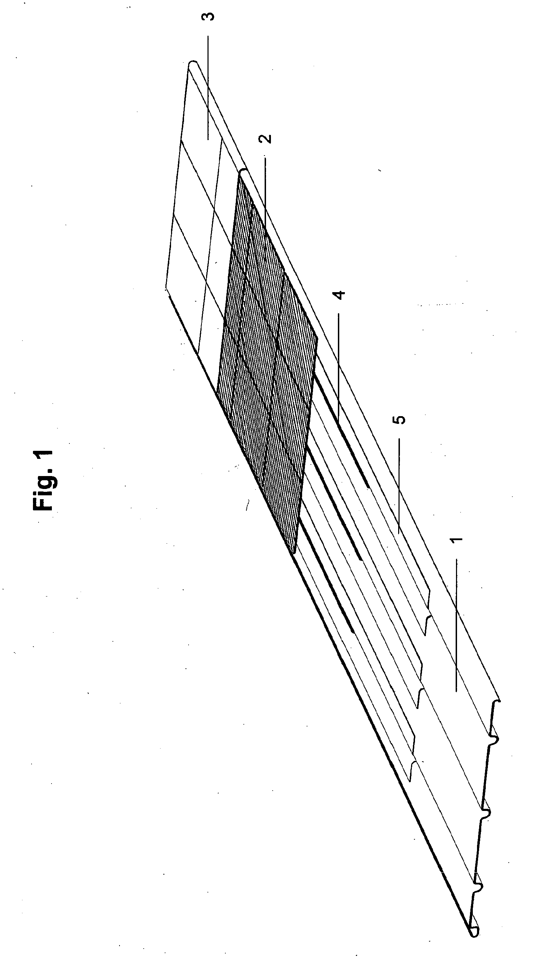

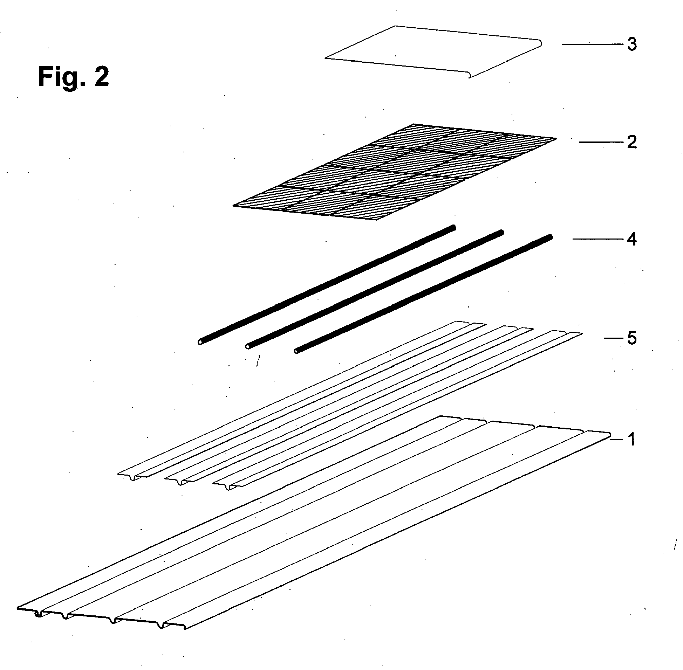

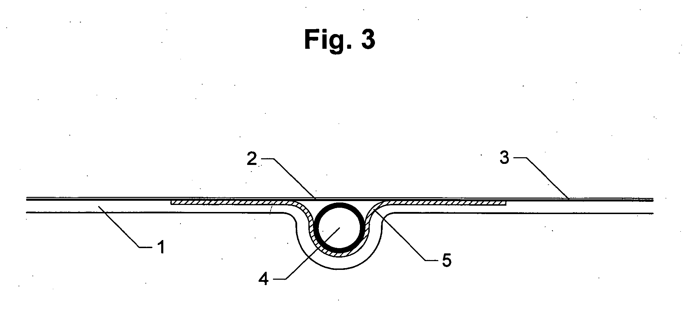

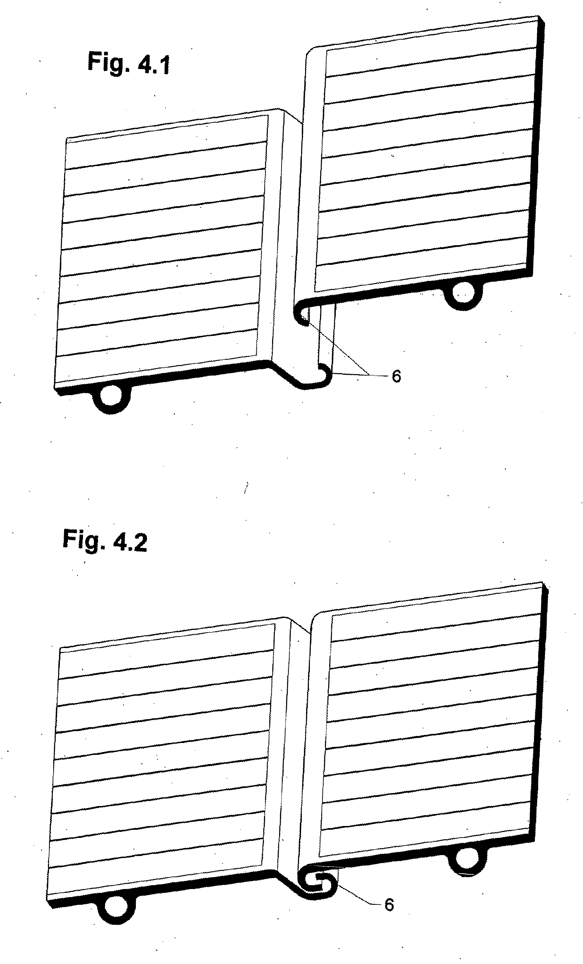

Erste Versuche bei dem Herstellen der beschriebenen Aufbau-Reihenfolge (Fig. 1-3) haben durch Messungen gezeigt, dass das Aufbringen einer Polyurethan- (PU) Beschichtung bzw. von Glasfaser-Laminat als obere Beschichtung (3) und die daraus resultierende Lichtbrechung zur Folge haben, dass sich der Wirkungsgrad der Photovoltaikzellen erhöht und eine Steigerung des Stromertrages zu erwarten ist.

Durch beliebige Laminateinfärbungen lassen sich in Verbindung mit den Photovoltaikzellen auch optisch und somit farblich schöne Kombinationen und Effekte für die Elemente erreichen, welches nur in dieser Verbindung als Einheit möglich sind. Und so lassen sich die Elemente gut an die architektonischen Anforderungen des Gesamtbauwerks anpassen und in ein Farb- und Materialkonzept einpassen.

## Patentansprüche

1. Das GFK Thermo- Photovoltaik Dacheindeckungs- und Wandverkleidungselement ist als alleiniges Dach- und Wandelement zu verstehen, das ebenso Photovoltaik- als auch Thermosolaranlage ist. Das "GFK Thermo- Photovoltaik Dacheindeckungs- und Wandverkleidungselement aus glasfaserverstärkten Kunststoffen als Träger mit den, der Dacheindeckungsrichtlinien entsprechenden Überlappungsgrößen zum Schutz vor eindringendem Regenwasser oder Feuchtigkeit, ist so gefertigt, dass die Aufnahme von einem Kühlleitungssystem mit Leiterlochplatten zur Ableitung der Wärme zur Steigerung des Wirkungsgrades der Photovoltaikzellen gewährleistet ist; diese Photovoltaikzellen, die im noch viskosen Zustand des GFK-Laminats auf die Schicht des Wärmeableitungssystems aufgebracht sind, erhalten nach der Aushärtung zum Schutz wiederum ein GFK-Laminat bzw. eine transparente Schutzschicht oder eine Polyurethan-(PU) Beschichtung.

2. Das "GFK Thermo- Photovoltaik Dacheindeckungs- und Wandverkleidungselement" nach Anspruch 1 wird durch die Verwendung von glasfaserverstärkten Kunststoffen individuell auf sämtliche Dachformen (Flach-, Sitz-, Sattel-, Walm-, Shed- oder weiteren Dachformen) bzw. Wandformen in großflächigen Elementen bis zu maximalen Transportgrößen hergestellt.

3. Das "GFK Thermo- Photovoltaik Dacheindeckungs- und Wandverkleidungselemente", welche nach Anspruch 1 bis 2 durch die in eine GFK Thermo- Photovoltaik Dacheindeckung und Wandverkleidung eingebaute Kühlung den Wirkungsgrad der Photovoltaikzelle erhöht, die Abwärme als thermosolare Energie an ein Speichermedium (Pufferspeicher) überträgt und so den Wirkungsgrad steigert.

4. Das "GFK Thermo- Photovoltaik Dacheindeckungs- und Wandverkleidungselement" nach Anspruch 1 bis 3 wird zur dekorativen besseren Anpassung beliebig eingefärbt.
